# EUROPÄISCHE PATENTSCHRIFT

(11) **EP 0 389 910 B1**
(45) Veröffentlichungstag und Bekanntmachung des Hinweises auf die Patenterteilung: **15.09.1993**
(21) Anmeldenummer: 90105147.4
(22) Anmeldetag: 19.03.1990
(51) Int. Cl.: H05K 7/18, H05K 9/00

(54) **Modulares Gehäusesystem für elektronische Baueinheiten**
Modular cabinet system for electronic assemblies
Systéme d'armoire modulaire pour unités électroniques

(30) Priorität: 28.03.1989 DE 3910056
(43) Veröffentlichungstag der Anmeldung: 03.10.1990
(73) Patentinhaber: Siemens Nixdorf Informationssysteme Aktiengesellschaft, 33102 Paderborn (DE)
(72) Erfinder: Schmalzl, Dieter, D-8900 Augsburg (DE); Bavar, Amir Houchang, D-8000 München 71 (DE); Scherer, August, Dipl.-Ing., D-8901 Dinkelscherben (DE)
(74) Vertreter: Fuchs, Franz-Josef, Dr.-Ing.

(56) Entgegenhaltungen:
- EP-A- 0 045 926
- FR-A- 2 111 035
- FR-A- 2 562 176
- US-A- 4 803 306

## Beschreibung

Die Erfindung betrifft ein modulares Gehäusesystem für elektronische Baueinheiten, insbesondere der Datentechnik, bestehend aus in der Längsrichtung mit Führungsrillen versehenen Holmen insbesondere aus Strangpreßprofil, die nach dem Baukastenprinzip mit Eckknoten und Verbindungselementen für den jeweiligen Verwendungszweck anpaßbar zusammengesetzt sind.

Der schnelle variable und einfach hochrüstbare Aufbau von elektronischen Geräten, insbesondere in der Datentechnik, erfordert ein umfangreiches Gehäusekonzept mit speziell darauf zugeschnittenem Anforderungsprofil. Bisher wurden des öfteren für kleinere Systeme und Geräte speziell nach den dafür erforderlichen Anforderungen entsprechende Gehäuse geschaffen. Dabei werden maximal im Gerüstbereich und bei diversen Fassadenteilen gleiche Grundkonstruktionen verwendet, die keine Höhenvariabilität zulassen. Der Nachteil dieser Systeme ist vor allem im immerwiederkehrenden Entwicklungsaufwand bei neuen Produkten zu sehen. Ein weiterer Nachteil ist die erheblich eingeschränkte Weiterverwendung von Teilen und Werkzeugen über mehrere Produkte hinweg. Die schwierigen nachträglichen Hochrüstungen und das uneinheitliche Erscheinungsbild über mehrere Produkte betrachtet, sind dabei zusätzliche Negativposten.

Das ist auch der Grund, warum man nach Möglichkeiten eines flexibleren Gehäuseaufbaus sucht. So gibt es beispielsweise zur Lösung unterschiedlicher technischer Probleme ein System, wie es im Prospekt der Firma ITEM, Industrietechnik und Maschinenbau, das Item MB-System, praktische Beispiele beschrieben ist. Bei diesem System werden Strangpreßprofile mit unterschiedlichen Querschnitten miteinander verschraubt und in Führungsnuten sind Nutensteine einsetzbar, mit denen eine Befestigung unterschiedlichster Elemente möglich ist. Dieses System ist jedoch hauptsächlich als Regalsystem für Werkstätten geeignet, um eine variable Lagerung unterschiedlichsten Lagergutes zu gewährleisten. Bei der Verwendung als Schranksystem, wie z.B. für die Datentechnik wären kleinere Abmessungen des Profils aus Gewichtsgründen notwendig. Dabei würden sich aber von der Art der Profilausgestaltung her erhebliche Probleme ergeben, da bei einer proportionalen Verkleinerung des dort gewählten Profils nicht mehr die nötige Festigkeit vorhanden wäre, um beispielsweise Schraubverbindungen und ähnliches anzubringen. Zudem müssen bei Eckverbindungen je nach Einsatzfall zusätzliche Löcher gebohrt werden, die die Montage erschweren und den zeitlichen Aufwand hierfür vergrößern.

Aus der deutschen Patentschrift 32 26 192 sind zwar zum Verbinden der Holme an den Ecken Eckverbinder zum Aufbau von Hohlrohrrahmengestellen bekannt, wobei die in drei senkrecht aufeinanderstehenden Richtungen ausgebildeten Eckverbinder in die Hohlrohre eingesteckt und mit diesen verklebt werden. Eine solche Konstruktion bringt jedoch die eingangs mit der Klebetechnik verbundenen Nachteile, z.B. einer hohen Rüstzeit, lange Aushärtzeit und dadurch ein hoher Bedarf an Fertigungsfläche und Vorrichtungen.

Aus EP-A-0045926 ist ferner ein Gehäuse für elektrotechnische Geräte bekannt. Dieses Gehäuse besteht aus einem Rahmen aus stranggepreßten Profilschienen, die miteinander verschraubt sind und zur Befestigung von Innenaufbauten als auch von Abdeckungen und Außenwänden im Profil T-Nuten haben, in denen Gleitmuttern zur Befestigung der Aufbauten liegen, wobei das Profil der den Rahmen bildenden Schienen symmetrisch auf jeder Außenseite angeordnet eine Kreuznut hat, die jeweils an der Außenseite offen ist, in die Gleitmuttern einlegbar sind und wobei diese Profile an den Ecken über würgelförmige Eckbausteine, die jeweils in Richtung der drei zu verbindenden Schienenzentrale Durchbrechungen für Schrauben haben, die in Bohrungen, speziell Gewindebohrungen, im Zentrum der Längsachse der Profile eingreifen.

Aufgabe der vorliegenden Erfindung ist es daher, ein Gehäusesystem zu schaffen, das einen schnellen variablen und einfach hochrüstbaren Aufbau von elektronischen Geräten, insbesondere der Datentechnik, gestattet.

Zur Lösung dieser Aufgabe wird das modulare Gehäusesystem gemäß dem Anspruch 1 derart ausgebildet, daß die Führungsrillen einen schlüssellochförmigen Querschnitt aufweisen und auf den Kanten und/oder parallel zu den Kanten und in deren Nähe auf den jeweiligen Seiten flächen der Holme verlaufen, daß in den Stirnflächen der Holme an den Rändern oder Kanten, an denen keine Führungsrillen verlaufen, Bohrungen und im Zentrum des Querschnitts der Stirnflächen eine weitere Bohrung vorgesehen sind, daß die Holme über Eckknoten miteinander verbindbar sind, und daß die Eckknoten an drei unterschiedlichen Koordinatenebenen zugeordneten Seiten mit jeweils zwei sich diagonal gegenüberstehenden Zapfen versehen sind, die in die stirnseitigen Bohrungen bzw. Führungsrillen der Holme eingreifen, daß jeweils zwischen den beiden Zapfen eine erste Bohrung kleineren Durchmessers, die im Innern des Eckknotens gesenkt ist, und in der gegenüberliegenden Fläche ohne Zapfen eine größere Bohrung vorgesehen ist, daß Holme und Eckknoten nach dem Ineinanderstecken mittels einer durch die Bohrung im Zentrum des Holmquerschnittes eingeführten, insbesondere selbstschneidenden Schraube verbunden sind, und daß in den Führungsrillen der Holme Halte- und/oder Federelemente verschiebbar anordenbar sind.

Durch diese Maßnahmen erhält man ein rasch aufbaubares, dem speziellen Einsatzfall anpaßbares und in einfacher Weise erweiterbares modulares Gehäusesystem. Um auch bei hohem Gewicht der Anbaueinheiten eine ausreichende Stabilität zu gewährleisten, kann das modulare Gehäusesystem auch derart ausgebildet sein, daß das Strangpreßprofil mindestens in einer Koordinatenrichtung die n-fache Abmessung des Ursprungsprofils hat und in den zusätzlichen Teilen die Führungsrillen und Bohrungen vorzugsweise mit der gleichen Konfiguration wie die des Ursprungsquerschnitts angeordnet sind.

Ferner können die Eckknoten mindestens in einer Koordinatenrichtung die mehrfache Abmessung gegenüber einem würfelförmig ausgebildeten Eckknoten aufweisen und ebensoviele Bohrungen pro Koordinatenebene mehr vorgesehen sein.

Als Halteelemente sind Nutensteine mit Stellschrauben vorgesehen. Es können aber auch als Halteelemente in die Führungsrillen eingreifbare Profile verwendet werden.

Zur HF-Abschirmung sind Federelemente vorgesehen, die in etwa W-förmig ausgebildet sind, wobei der obere Teil der Mittelschenkel des Federelementes im Querschnitt etwa ein nach unten offenes Trapez bildet, das als Führungselement in den Führungsrillen der Holme dient. Das Federelement kann auch aus zwei parallelen Schenkeln bestehen, die jeweils die Basis eines gleichschenkeligen Dreiecks bilden und die über ein etwa trapezförmiges Führungsteil miteinander verbunden sind, wobei das trapezförmige Führungsteil in den Führungsrillen der Holme führbar ist. Eine andere Ausgestaltung sieht vor, daß das Federelement etwa V-förmig ausgebildet ist, wobei der spitze Teil des Federelementes etwa ein Trapez bildet und der obere Teil der beiden Schenkel des Federelementes nach außen abgewinkelt und ein Teil parallel zum abgewinkelten Teil nach innen umgebogen verläuft.

Zur Abdichtung des Schrankes gegen Staub- und Schallaustritt und zur Reihung mehrerer Gehäusemodule neben- oder übereinander, können zwischen den einzelnen Modulen auch Dichtprofile oder Abstandshalter vorgesehen sein, die zwischen den beiden Federschenkeln einrastbar sind und die an einem Ende einen pfeilförmigen Querschnitt aufweisen und am andern Ende senkrecht zum Schaft des Pfeilquerschnitts eine trapezförmig ausgestaltete Leiste besitzen.

Zur größeren Stabilisierung der modularen Gehäuse können waagrecht verlaufenden Schienen an den senkrecht verlaufenden Holmen befestigt sein oder umgekehrt senkrecht verlaufende U-Schienen an den waagrecht verlaufenden Holmen.

Vorteilhafterweise lassen sich an den U-Schienen Geräte, wie z.B. Baugruppen, befestigen.

Um das modulare Gehäusesystem vor Schwingungen zu schützen, sind Gerüstfüße vorgesehen, die von unten über Traversen gegen das Gerüst geschraubt sind und die mit mindestens einem Hydrolager versehen und höhenverstellbar ausgebildet sind. Anstelle eines Hydrolagers kann auch bei geringerer Beanspruchung ein U-förmig ausgebildetes, schwingungsdämpfend wirkendes Blech vorgesehen sein, das zugleich als Träger für das Gerüst dient.

Um das Gerüstsystem zu einem Schrank zu vervollständigen, ist es vorteilhaft, durch die Nutensteine gehaltene Abdeckbleche vorzusehen und an der jeweils gewünschten Seite Türscharniere für Schranktüren aus den Nutensteinen zu befestigen.

Anhand der Ausführungsbeispiele nach den FIG 1 bis 7 wird die Erfindung näher erläutert. Es zeigen
FIG 1 eine Explosionszeichnung einer Gerüstkonstruktion,
FIG 2 einen Ausschnitt aus einer Gerüstkonstruktion mit Abdeckteilen,
FIG 3 Halteelemente, die als in Nuten eingreifbare Profile ausgebildet sind,
FIG 4 eine mit Quer- und Längsschienen verstärkte Gerätekonstruktion,
FIG 5 einen mit einem Hydrolager versehenen schwingungsdämpenden Fuß,
FIG 6 einen mit einem U-Eisen versehenen schwingungsdämpfenden Fuß,
FIG 7 eine Skizze zur Aneinanderreihbarkeit mehrerer Gehäuse.

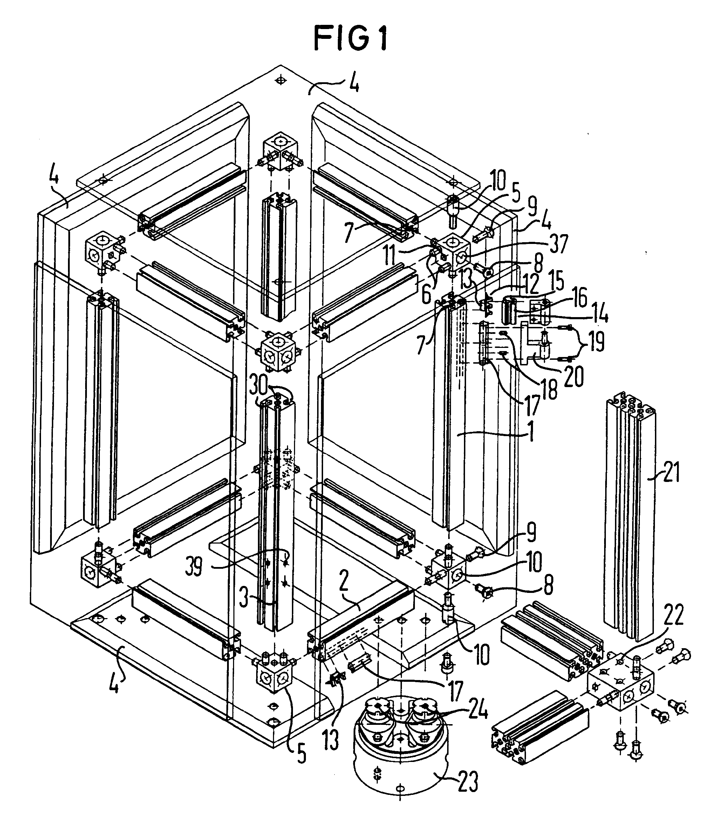

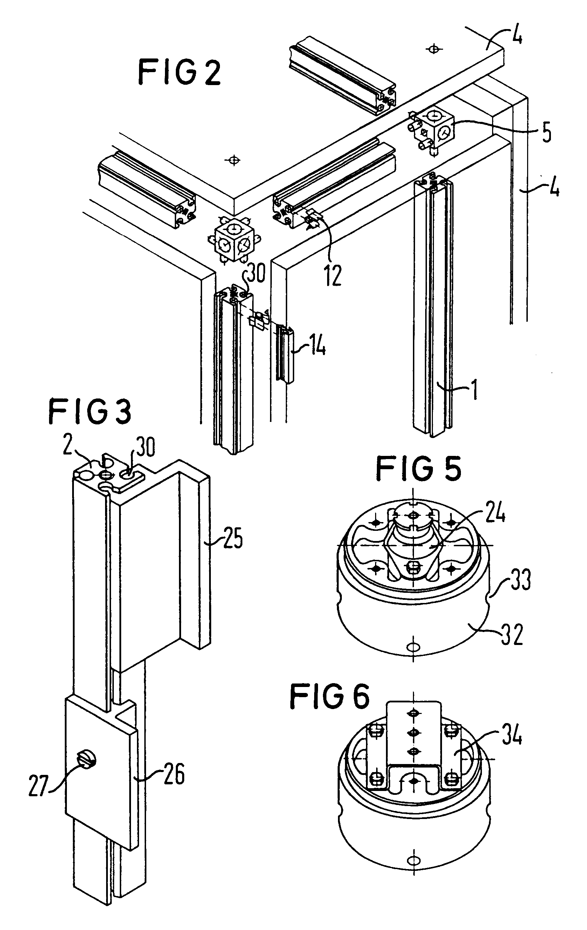

FIG 1 zeigt den Grundaufbau eines Datenschrankes mit Hilfe des modularen Gehäusesystems. Die Längsholme 1 und die Querholme 2 bestehen aus einem Strangpreßprofil, bei dem die Führungsrillen 3, 30 einen schlüssellochförmigen Querschnitt aufweisen. Dabei sind drei der Führungsrillen 30 parallel und in der Nähe der Kanten der Holme 1, 2, angebracht, während eine Führungsrille 3 an der Kante des Strangpreßprofils entlangläuft. Diese Führungsrille 3 könnte aber auch, wie die übrigen drei Führungsrillen 30 in der Nähe der Kante verlaufen, wobei das Entscheidungskriterium, welcher der Ausführungen der Vorzug gegeben wird, davon abhängt, ob die Abdeckbleche 4 in einem Winkel von 45° aneinander stoßen, wie in der vorliegenden FIG dargestellt oder mit einem Winkel von 90°, wie in FIG 2 gezeigt.

Die einzelnen Holme 1, 2 werden über Eckknoten 5 miteinander verbunden. Zu diesem Zweck sind in den Eckknoten auf jeweils drei zueinander senkrecht stehenden Seiten je zwei diagonal gegenüberstehende Zapfen 6 vorgesehen, die als Führungselemente in die Führungsrillen 3, 30 oder Bohrungen der Holme eingreifen. Im Zentrum der Holme ist eine Bohrung 7 angeordnet, in die die Schrauben 8, 9 und 10 vorzugsweise selbstschneidend eingeschraubt werden. Dabei ist der Eckknoten so ausgebildet, daß an denjenigen Seiten, an denen sich keine Zapfen befinden, eine Bohrung 37 vorgesehen ist, die so groß ist, daß der Schraubenkopf der Schrauben 8, 9, 10 hindurchgesteckt werden kann. Auf der gegenüberliegenden Seite, also jeweils zwischen den beiden Zapfen 6, ist eine kleinere Bohrung 11 angeordnet, die so groß ist, daß der Schraubenschaft der jeweiligen Schrauben 8, 9 oder 10 hindurchgesteckt werden kann. Außerdem ist diese Bohrung 11 im Innern des Würfels mit einer Senkung versehen, in die die Zylinderschrauben 8 bzw. 9 so versenkt sind, daß sie mit ihrer Schraubkopfoberfläche plan zur jeweils inneren Würfelseite sind, so daß dann die Schraube 10 problemlos ebenfalls in den Eckknoten und den dazugehörigen Holm eingesetzt werden kann. Sind nicht alle vier Seiten der Holme mit Führungsrillen versehen, so müssen an den übrigen entsprechende Sacklöcher oder durchgehende Bohrungen zum Einführen der Zapfen 6 vorgesehen werden.

Zur HF-Schirmung und zur Dichtung gegen Staub können in die Führungsrillen 3, 30 Federelemente 12 eingesetzt werden. Diese Federn sind in ihrem Querschnitt etwa W-förmig ausgebildet, wobei der obere Teil der Mittelschenkel der Federelemente im Querschnitt etwa ein nach unten offenes Trapez 13 bildet, das als Führungselement in den Führungsrillen 3, 30 der Holme 1, 2 dient. Die beiden äußeren Schenkel des Federelementes 12 können nun je nach Anwendungsfall nach außen oder nach innen abgeknickt sein. Zwischen die beiden Federbacken der Federelemente 12 lassen sich Dichtprofile 14 einrasten, die an einem Ende 15 einen pfeilförmigen Querschnitt aufweisen, mit dem sie in den trapezförmigen Querschnitt 13 der Federelemente 12 einrasten und sich dort verspreizen. Auf der gegenüberliegenden Seite am Pfeilschaft ist dann eine etwa trapezförmig ausgestaltete Leiste 16 angeordnet. Dieses Dichtprofil 14 kann auch als Abstandshalter montiert werden, wenn mehrere Gehäusemodule neben oder übereinander angeordnet werden sollen. So kann auch dort die HF-Verbindung und die Gehäuseabdichtung zwischen den Fassaden der Module in einfacher Weise hergestellt werden.

Als Halteelemente werden dabei Nutensteine 17 verwendet, die beispielsweise mit zwei Schrauben 18 in den Nuten festgeklemmt werden können, und die zusätzliche Schraublöcher aufweisen, in die beispielsweise Schrauben 19 eindrehbar sind, die, wie im vorliegenden Fall dargestellt, ein Türscharnier 20 am Nutenstein 17 festhalten. Rechts neben dem Gehäuse sind Holme 21 sowie ein Eckknoten 22 mit verdoppeltem Querschnitt für größere Belastung dargestellt.

An den vier Ecken eines Gehäuses werden Füße 23 angebracht, wobei der Einfachheit halber nur ein Fuß dargestellt ist, der jedoch mit zwei Hydrolagern 24, versehen ist, auf denen dann eine Traverse angebracht werden kann, die das Gehäuse trägt.

In FIG 2 ist ausschnittweise ein Gehäuse dargestellt, bei dem die Seitenabdeckungen 4 mit einem Winkel von 90° aufeinander stoßen, die Holme 1 sind dabei so ausgebildet, daß ihre Führungsrillen 30 jeweils parallel zu den Kanten an den Rändern der jeweiligen Seitenflächen der Holme 1, 2 verlaufen. Ansonsten ist die Konstruktion die gleiche, wie bereits anhand von FIG 1 beschrieben.

FIG 3 zeigt eine Ausführungsform, bei der anstatt der Nutensteine Profile 25, 26 als Halteelemente in die Führungsrillen 30 der Holme 1, 2 eingesetzt sind. Diese Profile können beispielsweise mit einer Schraube 27 befestigt werden.

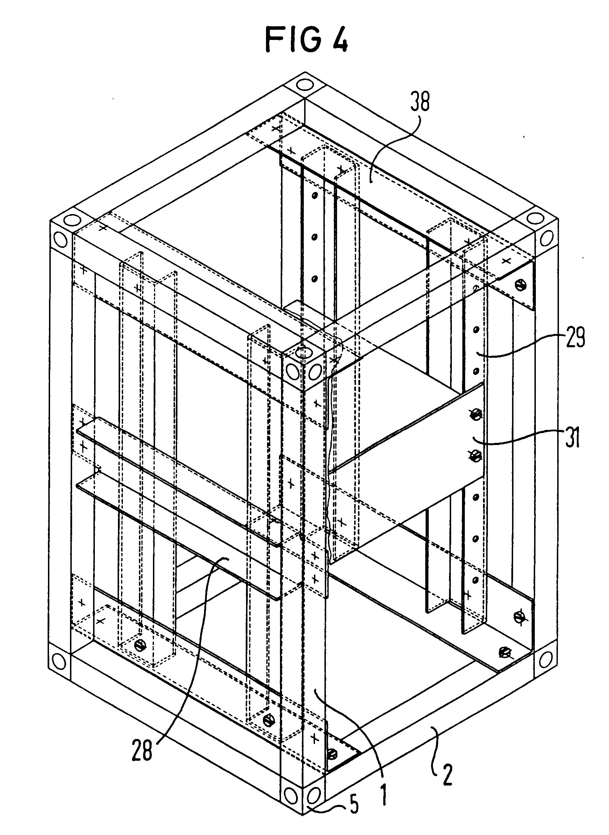

Wie man die Stabilität der Gerüste erhöhen kann, zeigt die FIG 4. Dort sind beispielsweise, parallel zu den Quer- und Längsholmen 2, U-Schienen 28, 29 vorgesehen. Diese U-Schienen können zugleich als Befestigungsmittel für elektronische Baueinheiten 31, wie z.B. Flachbaugruppen, benützt werden. Die Befestigungswinkel 38 der U-Schienen 29 verstärken gleichzeitig die stabilisierende Wirkung der Eckknoten.

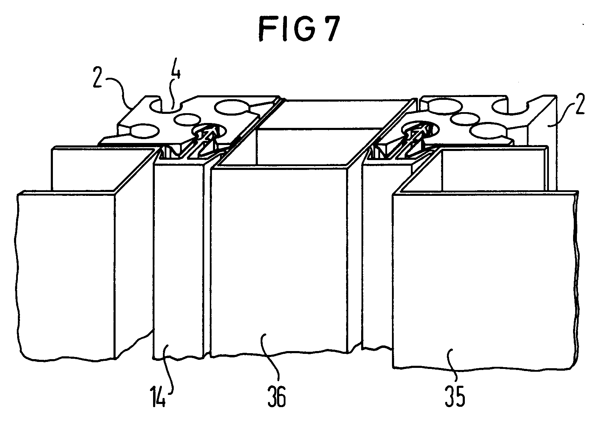

In FIG 5 ist ein schwingungsdämpfender Fuß 32 gezeigt, der nur mit einem Hydrolager 24 versehen ist. Dieser Fuß ist im Innern mit einer Gewindescheibe ausgestattet, die sich in einem im Fußteller eingelassenen Gewinde bewegen kann, wobei auf die Gewindescheibe das Hydrolager 24 aufgeschraubt ist, so daß durch Drehen des schalenförmigen Fußtellers, beispielsweise mit einem Schraubenzieher durch die Bohrungen 33, eine Höhenverstellung auch im montierten Zustand möglich ist. Dabei wird das Verstellen des Fußes noch dadurch erleichtert, daß der Fußteller an seiner Standseite nach außen ballig ausgebildet ist. Zugleich wird dadurch auch ein Schrägstehen des Fußes bei unterschiedlicher Belastung der jeweiligen Gehäuseseiten vermieden.

Ein einfacher Fuß für geringere Anforderung, was die Schwingungsdämpfung anbelangt, ist in FIG 6 dargestellt. Er ist konstruktiv gleich wie ein Fuß nach FIG 5 ausgestaltet, jedoch besitzt er anstelle eines Hydrolagers ein einfaches U-Blech 34 als schwingungsdämpfendes Element.

Wie mehrere Gehäuse zu einer einheitlichen Front aneinandergereiht werden können, zeigt FIG 7. Zwischen je zwei Gehäuse wird ein Abstandsstück 36 gesetzt. Die kleine verbleibende Lücke zwischen den Türen 35 und dem Abstandsstück 36 wird durch jeweils ein Dichtprofil 14 geschlossen. In äquivalenter Weise können auch mehrere Gehäuse übereinander gestapelt werden. Der Innenraum der auf diese Weise gestapelten bzw. gereihten Gehäuse ist dadurch wie das Einzelgehäuse HF-dicht abgeschirmt.

## Patentansprüche

1. Modulares Gehäusesystem für elektronische Baueinheiten, insbesondere der Datentechnik, bestehend aus in der Längsrichtung mit Führungsrillen versehenen Holmen z.B. aus Strangpreßprofil, die nach dem Baukastenprinzip mit Eckknoten und Verbindungselementen für den jeweiligen Verwendungszweck anpaßbar zusammengesetzt sind, wobei die Führungsrillen (3,30) einen schlüssellochförmigen Querschnitt aufweisen und auf den Kanten und/oder parallel dazu an den Rändern der jeweiligen Seitenflächen der Holme (1,2) verlaufen, wobei in den Stirnflächen der Holme (1,2) an den Rändern oder Kanten, an denen keine Führungsrillen (3,30) verlaufen, Bohrungen und im Zentrum des Querschnitts der Stirnflächen eine weitere Bohrung (7) vorgesehen sind, wobei die Holme (1,2) über Eckknoten (5) miteinander verbindbar sind, und wobei die Eckknoten (5) an drei unterschiedlichen Koordinatenebenen zugeordneten Seiten mit jeweils zwei sich diagonal gegenüberstehenden Zapfen (6) versehen sind, die in die stirnseitigen Bohrungen bzw. Führungsrillen (3,30) der Holme (1,2) eingreifen, wobei jeweils zwischen den beiden Zapfen (6) eine erste Bohrung (11) kleineren Durchmessers, die im Innern des Eckknotens (5) gesenkt ist, und in der gegenüberliegenden Fläche ohne Zapfen eine größere Bohrung (37) vorgesehen ist, wobei Holme (1,2) und Eckknoten (5) noch durch Ineinanderstecken mittels einer durch die Bohrungen (11,37) des Eckknotens (5) eingeführten und in die Bohrung (7) im Zentrum des Holmquerschnittes, vorzugsweise selbstschneidend, eingeführte Schrauben (8,9,10) verbunden sind, und wobei in den Führungsrillen (3,30) der Holme (1,2) Halte-(17) und/oder Federelemente (12) verschiebbar anordenbar sind.

2. Modulares Gehäusesystem für elektronische Baueinheiten nach Anspruch 1, **dadurch gekennzeichnet,** daß die Holme (1,2) mindestens in einer Koordinatenrichtung die n-fache Abmessung der Ursprungsholme hat und in den zusätzlichen Teilen die Führungsrillen (3,30) und Bohrungen mit der gleichen wie die des Ursprungsquerschnitts angeordnet sind.

3. Modulares Gehäusesystem für elektronische Baueinheiten nach einem der vorhergehenden Ansprüche, **dadurch gekennzeichnet,** daß die Eckknoten (5) mindestens in einer Koordinatenrichtung die n-fache Abmessung gegenüber einem würfelförmig ausgebildeten Eckknoten (5) aufweisen und ebenso viele Bohrungen pro Koordinatenebene mehr vorgesehen sind.

4. Modulares Gehäusesystem für elektronische Baueinheiten nach einem der vorhergehenden Ansprüche, **dadurch gekennzeichnet,** daß die Halteelemente als Nutensteine (17) mit Feststellschrauben (18) ausgebildet sind.

5. Modulares Gehäusesystem für elektronische Baueinheiten nach einem der Ansprüche 1 bis 3, **dadurch gekennzeichnet,** daß die Halteelemente als in die Nuten eingreifende Profile (25,26) ausgebildet sind.

6. Modulares Gehäusesystem für elektronische Baueinheiten nach einem der vorhergehenden Ansprüche, **dadurch gekennzeichnet,** daß die Federelemente (12) in etwa W-förmig ausgebildet sind, wobei die Mittelschenkel der Federelemente in ihrem oberen Teil im Querschnitt etwa ein nach unten offenes Trapez (12) bilden, das als Führungselement in den Führungsrillen der Holme (1,2) dient.

7. Modulares Gehäusesystem für elektronische Baueinheiten nach einem der Ansprüche 1 bis 5, **dadurch gekennzeichnet,** daß das Federelement (12) aus zwei parallelen Schenkeln besteht, die jeweils die Basis eines gleichschenkeligen Dreiecks bilden, und die über ein etwa trapezförmiges Führungsteil miteinander verbunden sind, wobei das trapezförmige Führungsteil in den Führungsrillen (3,30) der Holme (1,2) führbar ist.

8. Modulares Gehäusesystem für elektronische Baueinheiten nach einem der Ansprüche 1 bis 5, **dadurch gekennzeichnet,** daß das Federelement (12) etwa V-förmig ausgebildet ist, wobei der spitze Teil des Federelementes (12) etwa ein Trapez (13) bildet und der obere Teil der beiden Schenkel des Federelementes (12) nach außen abgewinkelt und ein Teil parallel zum abgewinkelten Teil nach innen umgebogen verläuft.

9. Modulares Gehäusesystem für elektronische Baueinheiten nach einem der vorhergehenden Ansprüche, **dadurch gekennzeichnet,** daß waagrecht verlaufende Schienen (28) an den senkrecht verlaufenden Holmen (1,2) befestigt sind.

10. Modulares Gehäusesystem für elektronische Baueinheiten nach einem der vorhergehenden Ansprüche, **dadurch gekennzeichnet,** daß senkrecht verlaufende U-Schienen (29) über Eckschienen (38) an den waagrecht verlaufenden Holmen (1,2) befestigbar sind.

11. Modulares Gehäusesystem für elektronische Baueinheiten nach einem der vorhergehenden Ansprüche, **dadurch gekennzeichnet,** daß an den U-Schienen (28,29) Geräte wie z.B. Baugruppen (31) befestigbar sind.

12. Modulares Gehäusesystem für elektronische Baueinheiten nach einem der vorhergehenden Ansprüche, **dadurch gekennzeichnet,** daß Gerüstfüße (32) vorgesehen sind, die von unten über Traversen gegen das Gerüst geschraubt sind, und die mit mindestens einem Hydrolager (24) versehen und höhenverstellbar ausgebildet sind.

13. Modulares Gehäusesystem für elektronische Baueinheiten nach Anspruch 12, **dadurch gekennzeichnet,** daß anstelle eines Hydrolagers ein U-förmig ausgebildetes schwingungsdämpfend wirkendes Blech (34) vorgesehen ist.

14. Modulares Gehäusesystem für elektronische Baueinheiten nach einem der vorhergehenden Ansprüche, **dadurch gekennzeichnet,** daß die Gerüste mit durch Nutensteine (17) gehaltenen Abdeckungen (4) versehen sind.

15. Modulares Gehäusesystem für elektronische Baueinheiten nach einem der vorhergehenden Ansprüche, **dadurch gekennzeichnet,** daß an den Nutensteinen (17) Türscharniere (18) befestigbar sind.

16. Modulares Gehäusesystem für elektronische Baueinheiten nach einem der vorhergehenden Ansprüche, **dadurch gekennzeichnet,** daß senkrecht zu den Führungsrillen und jeweils zwischen zwei Führungsrillen verlaufend Gewindebohrungen (39) anbringbar sind.

## Claims

1. Modular housing system for electronic assemblies, particularly in the field of data technology, comprising struts, for example of extruded sections, which are provided in the longitudinal direction with guide grooves and are assembled on the modular principle with corner nodes and connecting elements such that they can be adapted for the respective purpose, the guide grooves (3, 30) having a keyhole-shaped cross-section and running on the edges and/or parallel thereto on the borders of the respective side faces of the struts (1, 2), bores being provided in the end faces of the struts (1, 2) on the borders or edges on which no guide grooves (3, 30) run, and a further bore (7) being provided in the centre of the cross-section of the end faces, the struts (1, 2) being connectable to one another by means of corner nodes (5), and the corner nodes (5) being provided on each of three sides, allocated to different coordinate planes, with two diagonally opposite pegs (6), which engage in the end-face bores or guide grooves (3, 30) of the struts (1, 2), there being provided in each case between the two pegs (6) a first bore (11) of smaller diameter, which is made in the inside of the corner node (5), and a larger bore (37) being provided in the opposite face, without a peg, struts (1, 2) and corner nodes (5) being connected furthermore by fitting one into the other by means of a screw (8) inserted through the bores (11, 37) of the corner node (5) and screws (9, 10) inserted in the bore (7) in the centre of the strut cross-section, the said screws preferably being self-tapping, and it being possible for holding elements (17) and/or tongue elements (12) to be arranged displaceably in the guide grooves (3, 30) of the struts (1, 2).

2. Modular housing system for electronic assemblies according to Claim 1, characterised in that the struts (1, 2) have, at least in one coordinate direction, the n-fold dimension of the original struts and the guide grooves (3, 30) and bores are arranged in the additional parts with the same configuration as that of the original cross-section.

3. Modular housing system for electronic assemblies according to one of the preceding claims, characterised in that the corner nodes (5) have, at least in one coordinate direction, the n-fold dimension compared to a cubically designed corner node (5) and the same number of bores are added per coordinate plane.

4. Modular housing system for electronic assemblies according to one of the preceding claims, characterised in that the holding elements are designed as grooved blocks (17) with fixing screws (18).

5. Modular housing system for electronic assemblies according to one of Claims 1 to 3, characterised in that the holding elements are designed as profiles (25, 26) engaging in the grooves.

6. Modular housing system for electronic assemblies according to one of the preceding claims, characterised in that the tongue elements (12) are designed approximately W-shaped, the middle leg of the tongue elements forming cross-sectionally in their upper part approximately a downwardly open trapezoid (12), which serves as a guide element in the guide grooves of the struts (1, 2).

7. Modular housing system for electronic assemblies according to one of Claims 1 to 5, characterised in that the tongue element (12) comprises two parallel legs, which in each case form the base of an equilateral triangle, and which are connected to each other via an approximately trapezoidal guide part, the trapezoidal guide part being guidable in the guide grooves (3, 30) of the struts (1, 2).

8. Modular housing system for electronic assemblies according to one of Claims 1 to 5, characterised in that the tongue element (12) is designed approximately V-shaped, the pointed part of the tongue element (12) approximately forming a trapezoid (13) and the upper part of the two legs of the tongue element (12) being angled off outwards and a part parallel to the angled-off part being bent around inwards.

9. Modular housing system for electronic assemblies according to one of the preceding claims, characterised in that horizontally running rails (28) are fastened on the vertically running struts (1, 2).

10. Modular housing system for electronic assemblies according to one of the preceding claims, characterised in that vertically running U-rails (29) can be fastened by means of corner rails (38) on the horizontally running struts (1, 2).

11. Modular housing system for electronic assemblies according to one of the preceding claims, characterised in that equipment, such as for example assembly groups (31), can be fastened on the U-rails (28, 29).

12. Modular housing system for electronic assemblies according to one of the preceding claims, characterised in that frame feet (32) are provided, which are screwed from below via cross-members against the frame, and which are provided with at least one hydraulic bearing (24) and are of a height-adjustable design.

13. Modular housing system for electronic assemblies according to Claim 12, characterised in that, instead of a hydraulic bearing, a plate (34) of a U-shaped design and with a vibration-damping effect is provided.

14. Modular housing system for electronic assemblies according to one of the preceding claims, characterised in that the frames are provided with coverings (4) held by grooved blocks (17).

15. Modular housing system for electronic assemblies according to one of the preceding claims, characterised in that door hinges (18) can be fastened on the grooved blocks (17).

16. Modular housing system for electronic assemblies according to one of the preceding claims, characterised in that threaded bores (39) can be made perpendicularly to the guide grooves and running in each case between two guide grooves.

## Revendications

1. Système de boîtier modulaire pour modules électroniques, notamment de la technique de transmission des données, constitué par des longerons comportant des rainures de guidage dans la direction longitudinale et formés par exemple par un profilé extrudé et qui sont réunis d'une manière pouvant être adaptée au but respectif d'utilisation, selon le principe modulaire, avec des noeuds d'angle et des éléments de jonction, et dans lequel les rainures de guidage (3,30) possèdent une section transversale en forme de trou de serrure et s'étendent au niveau des arêtes et/ou parallèlement à ces dernières, sur les bords des surfaces latérales respectives des longerons (1,2), et dans lequel il est prévu des perçages dans les surfaces frontales des longerons (1,2) dans les bords ou sur les arêtes, au niveau desquels ne s'étend aucune rainure de guidge (3,30), et un autre perçage (7) au centre de la section transversale des surfaces frontales, et dans lequel les longerons (1,2) peuvent être reliés entre eux par l'intermédiaire de noeuds d'angle (5), et dans lequel les noeuds d'angle (5) comportent, sur trois côtés associés à des plans de coordonnées différents, respectivement deux tétons (6) opposés en diagonale, qui s'engagent dans les perçages frontaux ou les rainures de guidage frontales (3,30) des longerons (1,2), et dans lequel il est prévu un premier perçage de diamètre réduit (11), qui est disposé en renfoncement à l'intérieur du noeud d'angle (5), entre les deux tétons (6), et un perçage de taille supérieure (37) dans la surface opposée ne comportant aucun téton, et dans lequel les longerons (1,2) et les noeuds d'angle (5) sont en outre raccordés, avec emboîtement réciproque, au moyen d'une vis (8,9,10), qui est insérée dans les perçages (11,37) du noeud d'angle (5) et est insérée, de préférence avec un effet d'autotaraudage, dans le perçage (7) situé au centre de la section transversale des longerons, et dans lequel des éléments de retenue (17) et/ou des éléments élastiques (12) peuvent être disposés de manière à être déplaçables dans les rainures de guidage (3,30) des longerons (1,2).

2. Système de boîtier modulaire pour modules électroniques suivant la revendication 1, caractérisé par le fait que les longerons (1,2) possèdent, au moins dans une direction de coordonnées, n fois la dimension des longerons d'origine, et que les rainures de guidage (3,30) et des perçages possédant une section transversale identique à la section transversale d'origine sont prévus dans les parties supplémentaires.

3. Système de boîtier modulaire pour modules électroniques suivant l'une des revendications précédentes, caractérisé par le fait que les noeuds d'angle (5) possèdent au moins dans une direction de coordonnées, une dimension n fois supérieure, par rapport à un noeud d'angle (5) agencé en forme de cube, et que, également, un grand nombre de perçages sont prévus en supplément pour chaque plan de coordonnées.

4. Système de boîtier modulaire pour modules électroniques suivant l'une des revendications précédentes, caractérisé par le fait que les éléments de retenue sont réalisés sous la forme de coulisseaux (17) comportant des vis de serrage (18).

5. Système de boîtier modulaire pour modules électroniques suivant l'une des revendications 1 à 3, caractérisé par le fait que les éléments de retenue sont agencés sous la forme de profilés (25,26) qui s'engagent dans les rainures.

6. Système de boîtier modulaire pour modules électroniques suivant l'une des revendications précédentes, caractérisé par le fait que les éléments de ressort (12) sont réalisés approximativement avec la forme d'un W, les branches médianes des éléments de ressort formant en coupe transversale, dans leur partie supérieure, approximativement un trapèze (12) ouvert vers le bas, qui sert d'élément de guidage dans les rainures de guidage des longerons (1,2).

7. Système de boîtier modulaire pour modules électroniques suivant l'une des revendications 1 à 5, caractérisé par le fait que l'élément de ressort (12) est constitué par deux branches parallèles, qui forment respectivement la base d'un triangle isocèle et qui sont raccordées entre elles par l'intermédiaire d'un élément de guidage approximativement trapézoïdal, l'élément de guidage trapézoïdal pouvant être inséré dans les rainures de guidage (3,30) des longerons (1,2).

8. Système de boîtier modulaire pour modules électroniques suivant l'une des revendications 1 à 5, caractérisé par le fait que l'élément de ressort (12) est réalisé approximativement en forme de V, la partie pointue de l'élément de ressort (12) formant approximativement un trapèze (13), tandis que la partie supérieure des deux branches de l'élément de ressort (12) sont repliées vers l'extérieur et qu'une partie parallèle à la partie repliée est recourbée vers l'intérieur.

9. Système de boîtier modulaire pour modules électroniques suivant l'une des revendications précédentes, caractérisé par le fait que des rails horizontaux (28) sont fixés aux deux longerons verticaux (1,2).

10. Système de boîtier modulaire pour modules électroniques suivant l'une des revendications précédentes, caractérisé par le fait que des rails verticaux en forme de U (29) peuvent être fixés, au moyen de rails d'angle (38), aux longerons horizontaux (1,2).

11. Système de boîtier modulaire pour modules électroniques suivant l'une des revendications précédentes, caractérisé par le fait que des appareils, comme par exemple des modules (31), peuvent être fixés aux rails en forme de U (28,29).

12. Système de boîtier modulaire pour modules électroniques suivant l'une des revendications précédentes, caractérisé par le fait qu'il est prévu des pieds d'ossature (32), qui sont vissés à partir du bas, par l'intermédiaire de traverses, à l'ossature et qui sont équipés au moins d'un palier hydrostatique (24) et sont agencés de manière à être réglables en hauteur.

13. Système de boîtier modulaire pour modules électroniques suivant la revendication 12, caractérisé par le fait qu'à la place du palier hydrostatique, il est prévu une tôle (34) réalisée en forme de U et agissant en tant qu'amortisseur de vibrations.

14. Système de boîtier modulaire pour modules électroniques suivant l'une des revendications précédentes, caractérisé par le fait que les ossatures sont équipées de revêtements (4) maintenus par des coulisseaux (17).

15. Système de boîtier modulaire pour modules électroniques suivant l'une des revendications précédentes, caractérisé par le fait que des charnières de porte (18) peuvent être fixées aux coulisseaux (17).

16. Système de boîtier modulaire pour modules électroniques suivant l'une des revendications précédentes, caractérisé par le fait que des trous taraudés (39) peuvent être formés perpendiculairement aux rainures de guidage, de manière à s'étendre respectivement entre deux rainures de guidage.
